# EUROPEAN PATENT APPLICATION

(11) **EP 3 764 112 A1**
(43) Date of publication of application: **13.01.2021**
(21) Application number: 19215154.6
(22) Date of filing: 11.12.2019
(51) Int. Cl.: G01R 31/3183

(54) **SYSTEMS AND METHODS FOR FUZZING WITH FEEDBACK**

(30) Priority: 11.07.2019 US 201916509174
(71) Applicant: Rockwell Collins, Inc., Cedar Rapids, IA 52498 (US)
(72) Inventor: COPPA, Ryan J., Cedar Rapids, IA 52402 (US); GREVE, David A., Cedar Rapids, IA 52402 (US); RYON, Luke E., Cedar Rapids, IA 52402 (US); GOETZMAN, Charles E., Cedar Rapids, IA 52402 (US)
(74) Representative: Dehns

(57) **Abstract**

A system can include one or more processors (112) and computer-readable instructions that when executed by the one or more processors (112), cause the one or more processors (112) to provide a first test signal (216) to an electronic device (128), monitor at least one parameter of the electronic device (128) during a time period subsequent to the test signal (216) being provided to the electronic device (128), determine, based on the at least one parameter, a detected response of the electronic device (128) to the first test signal (216), determine, using a response model (204), an expected response of the electronic device (128) to the first test signal (216), and provide a second test signal (216) based on the detected response and the expected response to the electronic device (128). The system can include a communications circuit (120) that provides the test signal (216) and receives at least some feedback (220) indicating the parameters, and sensors (124) that receive at least some feedback (220) indicating the parameters.

## Description

### BACKGROUND

The present disclosure relates generally to the field of electronic device testing. More particularly, embodiments of the inventive concepts disclosed herein relate to systems and methods for fuzzing with feedback.

Fuzzing can be used to test electronic devices, such as to test software or firmware operated by the electronic devices. For example, fuzzing can be used to provide inputs to the electronic devices intended to cause unexpected behaviors in the electronic devices.

### SUMMAR Y

From a first aspect, there is provided a method comprising: providing, by one or more processors to an electronic device, a first test signal; monitoring, by the one or more processors, at least one parameter of the electronic device during a time period subsequent to the test signal being provided to the electronic device; determining, by the one or more processors based on the at least one parameter, a detected response of the electronic device to the first test signal; determining, by the one or more processors using a response model, an expected response of the electronic device to the first test signal; and providing, by the one or more processors to the electronic device, a second test signal based on the detected response and the expected response.

From a further aspect, there is provided a system comprising: one or more processors and computer-readable instructions that when executed by the one or more processors, cause the one or more processors to provide a first test signal to an electronic device, monitor at least one parameter of the electronic device during a time period subsequent to the test signal being provided to the electronic device, determine, based on the at least one parameter, a detected response of the electronic device to the first test signal, determine, using a response model, an expected response of the electronic device to the first test signal, and provide a second test signal based on the detected response and the expected response to the electronic device.

### BRIEF DESCRIPTION OF THE DRAWINGS

Implementations of the inventive concepts disclosed herein may be better understood when consideration is given to the following detailed description thereof. Such description makes reference to the included drawings which are exemplary only, which are not necessarily to scale, and in which some features may be exaggerated and some features may be omitted or may be represented schematically in the interest of clarity. Like reference numerals in the drawings may represent and refer to the same or similar element, feature, or function. In the drawings:
FIG. 1 is a schematic diagram of a fuzzing system;
FIG. 2 is a schematic diagram of a fuzzer of the fuzzing system of FIG. 1;
FIG. 3 is a schematic diagram of a machine learning system that can be used by a fuzzing system;
FIG. 4 is a schematic diagram of a process for correlating feedback; and
FIG. 5 is a flow diagram of a method for fuzzing with feedback.

### DETAILED DESCRIPTION

Before explaining at least one embodiment of the inventive concepts disclosed herein in detail, it is to be understood that the inventive concepts are not limited in their application to the details of construction and the arrangement of the components or steps or methodologies set forth in the following description or illustrated in the drawings. In the following detailed description of embodiments of the instant inventive concepts, numerous specific details are set forth in order to provide a more thorough understanding of the inventive concepts. However, it will be apparent to one of ordinary skill in the art having the benefit of the instant disclosure that the inventive concepts disclosed herein may be practiced without these specific details. In other instances, well-known features may not be described in detail to avoid unnecessarily complicating the instant disclosure. The inventive concepts disclosed herein are capable of other embodiments or of being practiced or carried out in various ways. Also, it is to be understood that the phraseology and terminology employed herein is for the purpose of description and should not be regarded as limiting.

As used herein a letter following a reference numeral is intended to reference an embodiment of the feature or element that may be similar, but not necessarily identical, to a previously described element or feature bearing the same reference numeral (e.g., 1, 1a, 1b). Such shorthand notations are used for purposes of convenience only, and should not be construed to limit the inventive concepts disclosed herein in any way unless expressly stated to the contrary.

Further, unless expressly stated to the contrary, "or" refers to an inclusive or and not to an exclusive or. For example, a condition A or B is satisfied by any one of the following: A is true (or present) and B is false (or not present), A is false (or not present) and B is true (or present), or both A and B are true (or present).

In addition, use of the "a" or "an" are employed to describe elements and components of embodiments of the instant inventive concepts. This is done merely for convenience and to give a general sense of the inventive concepts, and "a" and "an" are intended to include one or at least one and the singular also includes the plural unless it is obvious that it is meant otherwise.

Finally, as used herein any reference to "one embodiment" or "some embodiments" means that a particular element, feature, structure, or characteristic described in connection with the embodiment is included in at least one embodiment of the inventive concepts disclosed herein. The appearances of the phrase "in some embodiments" in various places in the specification are not necessarily all referring to the same embodiment, and embodiments of the inventive concepts disclosed may include one or more of the features expressly described or inherently present herein, or any combination or sub-combination of two or more such features, along with any other features which may not necessarily be expressly described or inherently present in the instant disclosure.

Broadly, embodiments of the inventive concepts disclosed herein are directed to systems and methods for fuzzing with feedback. The systems can detect observables regarding a unit under test (UUT), compare the detected observables to a baseline of expected behavior, and adjust the fuzzing responsive to the comparison. In some embodiments, a system includes one or more processors and computer-readable instructions that when executed by the one or more processors, cause the one or more processors to provide a first test signal to an electronic device, monitor at least one parameter of the electronic device during a time period subsequent to the test signal being provided to the electronic device, determine, based on the at least one parameter, a detected response of the electronic device to the first test signal, determine, using a response model, an expected response of the electronic device to the first test signal, and provide a second test signal based on the detected response and the expected response to the electronic device.

The inventive concepts disclosed herein can be utilized in a number of communication systems, including routers, network switches, handheld radios, backpack radios, software defined radios (SDRs), end user devices, and gateways. The inventive concepts disclosed herein can be used for various types of electronic avionics applications for ground-based platforms and airborne platforms (e.g., aircraft), including but not limited to flight control and autopilot systems, navigation systems, flight display systems, communications systems, radar systems, electric power systems, engine control systems, and monitor warning systems.

The inventive concepts disclosed herein can be used to improve fuzzing technologies by detecting and processing feedback received from performing fuzzing. Some fuzzers operate in an open loop manner, in which the fuzzer generates tests cases and provides those tests cases to the UUT; the feedback received is typically a failure of the UUT, such as the UUT crashing, or code coverage, which can limit the ability of the fuzzer to identify interesting test cases. This may result in the fuzzer being unable to detect other test cases that may be of interest. Systems and methods in accordance with the inventive concepts disclosed herein can identify feedback in addition to crash events, and can effectively use such feedback to identify interesting test cases and determine how to generate further test case signals based on the feedback. Systems and methods in accordance with the inventive concepts disclosed herein can operate a model that generates a predicted or expected response of the electronic device to the test signals, and can update the model responsive to the feedback. Systems and methods in accordance with the inventive concepts disclosed herein can extend the use of fuzzing to a variety of UUTs, such as embedded software, UUTs that are limited in the types of parameters that can be measured, and UUTs operated in constrained environments. Systems and methods in accordance with the inventive concepts disclosed herein can detect feedback regarding electronic devices even if the electronic devices are operating as black box devices.

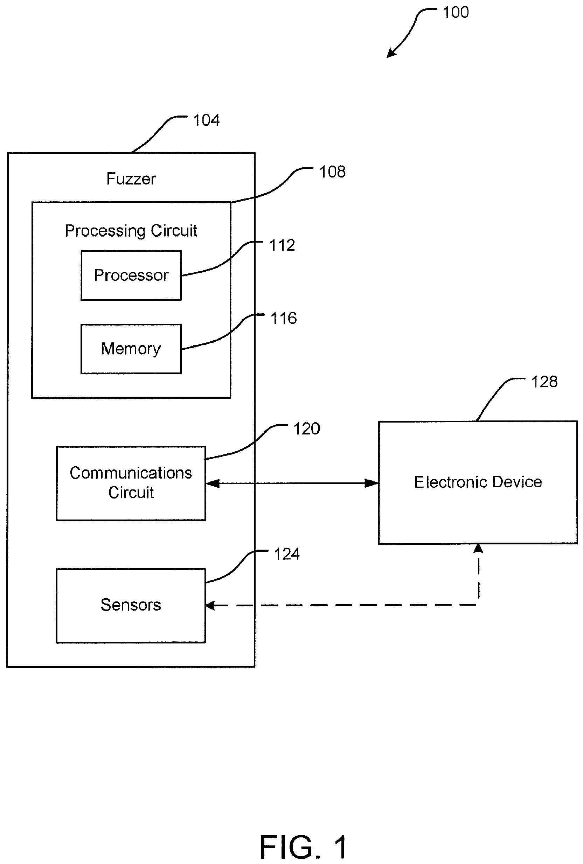

Referring now to FIG. 1, an embodiment of a fuzzing system 100 according to the inventive concepts disclosed herein includes a fuzzer 104 that can provide test signals to an electronic device 128. The fuzzer 104 and electronic device 128 may be separate electronic devices. The fuzzer 104 and electronic device 128 may at least partially operate on shared processing hardware, including but not limited to being implemented by a system on a chip (SoC) or by various cores of a multi-core processing system. At least a portion of the fuzzer 104 may be implemented by the electronic device 128; for example, the functionality described with reference to processing circuit 108 may be at least partially implemented by processing electronics of the electronic device 128.

The fuzzer 104 can include a processing circuit 108. The processing circuit 108 can include includes a processor 112 and memory 116. The processor 112 may be implemented as a specific purpose processor, an application specific integrated circuit (ASIC), one or more field programmable gate arrays (FPGAs), a group of processing components, or other suitable electronic processing components. The memory 116 is one or more devices (e.g., RAM, ROM, flash memory, hard disk storage) for storing data and computer code for completing and facilitating the various user or client processes, layers, and modules described in the present disclosure. The memory 116 may be or include volatile memory or non-volatile memory and may include database components, object code components, script components, or any other type of information structure for supporting the various activities and information structures of the inventive concepts disclosed herein. The memory 116 is communicably connected to the processor 112 and includes computer code or instruction modules for executing one or more processes described herein. The memory 116 includes various circuits, software engines, and/or modules that cause the processor 112 to execute the systems and methods described herein, such as to generate test signals to provide to the electronic device 128, operate various models that can predict the response of the electronic device 128 to the test signal, and process feedback received from the electronic device 128 responsive to the electronic device 128 processing the test signal.

The fuzzer 104 can include a communications circuit 120. The communications circuit 120 can include wired or wireless interfaces (e.g., jacks, antennas, transmitters, receivers, transceivers, wire terminals, etc.) for conducting data communications with various systems, devices, or networks, including the electronic device 128. For example, the communications circuit 120 can include an Ethernet card and port for sending and receiving data via an Ethernet-based communications network. The communications circuit 120 can include a WiFi transceiver for communicating via a wireless communications network. The communications circuit 120 can communicate via local area networks (e.g., a building LAN), wide area networks (e.g., the Internet, a cellular network), and/or conduct direct communications (e.g., NFC, Bluetooth). The communications circuit 120 can conduct wired and/or wireless communications. For example, the communications circuit 120 can include one or more wireless transceivers (e.g., a Wi-Fi transceiver, a Bluetooth transceiver, a NFC transceiver, a cellular transceiver). The communications circuit 120 can include a memory bus.

The communications circuit 120 can provide a test signal generated by the processing circuit 108 to the electronic device 128, using any of a variety of wired or wireless communications protocols. The communications circuit 120 can receive at least some feedback from the electronic device 128 responsive to the electronic device 128 processing the test signal, such as a message reply or status or state information, based on which the processing circuit 108 can monitor at least one parameter of the electronic device 128.

The fuzzer 104 can include one or more sensors 124. The processing circuit 108 can use the one or more sensors 124 to monitor at least one parameter of the electronic device 128 during a time period subsequent to the test signal being provided to the electronic device 128. The one or more sensors 124 can be used to detect feedback that may not be received via a connection between the communications circuit 120 and the electronic device 128 (e.g., may not be direct observables). The one or more sensors 124 can communicate with the processing circuit 108 directly or via the communications circuit 120 to provide the feedback to the processing circuit 108 based on which the processing circuit 108 can monitor the at least one parameter.

In some embodiments, the one or more sensors 124 include a radio frequency (RF) emissions detector. The RF emissions detector can detect RF emissions generated by the electronic device 128 before, during, or after the electronic device 128 processes the test signal (which may be distinct from RF signals generated by a communications circuit of the electronic device 128 to communicate with the communications circuit 120 in response to the electronic device 128 processing the test signal). The RF emissions detector can include various antennas, radios, RF receivers, analog-to-digital converters, or combinations thereof that can detect an RF signal outputted by the electronic device 128 and provide the RF signal (e.g., a digital signal corresponding to the RF signal) to the processing circuit 108.

In some embodiments, the one or more sensors 124 include a power sensor. The power sensor can detect power draw by the electronic device 128 before, during, or after the electronic device 128 processes the test signal. For example, the power sensor can be coupled with a power supply (not shown) that the electronic device 128 uses to operate or a connection between the power supply and the electronic device 128. The power sensor can include various resistors or other electronic components that can be used to determine the power used by the electronic device 128. The power sensor can include a power sensor of the power supply.

In some embodiments, the one or more sensors 124 include a temperature sensor. The temperature sensor can be used to detect at least one of a temperature of the electronic device 128 or heat generated by the electronic device 128. The temperature sensor can include any of a variety of temperature sensors or combinations thereof such as thermocouples, thermally sensitive resistors, resistance temperature detectors, or infrared sensors. The temperature sensor can be mounted to the electronic device 128 or located at a distance from the electronic device 128.

The electronic device 128 (e.g., UUT) can be any device or component thereof operating software or firmware to be tested by the test signal provided by the fuzzer 104. The electronic device 128 can include a processing circuit similar to the processing circuit 108 that can operate on the test signal. For example, the electronic device 128 can include software or firmware that operates on the test signal. The electronic device 128 can include a communications circuit similar to the communications circuit 120 to provide output signals that can be received and can be processed by the fuzzer 104. The electronic device 128 can include devices such as circuit boards, radios, software-defined radios, transceivers, sensors, machines, controllers, or other devices that can perform electronic operations responsive to receiving the test signal from the fuzzer 104. The electronic device 128 can operate according to a joint test action group (JTAG) protocol, such as by including a JTAG port that can operate with a JTAG debugger of the fuzzer 104. The electronic device 128 can be a virtual platform, such as a simulated version of a device that is operating on a processing circuit and may have software or firmware interfaces in place of corresponding hardware interfaces of a hardware component.

In some embodiments, the electronic device 128 generates and outputs direct observables that can be received as feedback by the fuzzer 104. The direct observables can include a message, such as a message reply, that the electronic device 128 generates responsive to processing the test signal. The direct observable can indicate a state (e.g., status) of the electronic device 128 that the electronic device 128 outputs periodically, responsive to a state change, or responsive to receiving a request from the fuzzer 104. For example, the fuzzer 104 can transmit a query to the electronic device 128 for the status, which the electronic device 128 can provide responsive to the query. The fuzzer 104 can operate a JTAG debugger to query the electronic device 128 for the state. The state can correspond to an operational mode of the electronic device 128 (e.g., on, ready for processing, ready to receive inputs, processing inputs, sleep, hibernation) or a function being performed by the electronic device 128. The state can indicate an amount of processing load, or processing capacity or memory capacity available for operation by the electronic device 128. The state can indicate a network connection status or characteristic, such as latency. The state can include a current step of a protocol or an operational configuration of the electronic device 128.

The fuzzer 104 can receive feedback including a processor loading feedback. For example, the fuzzer 104 can monitor operation of the electronic device 128 (e.g., via communications circuit 120) to receive an indication of a duration of time that one or more processors of the electronic device 128 are in a loading state.

The fuzzer 104 can receive feedback including an indication of message latency. For example, the fuzzer 104 can monitor a duration of time between when a test signal is sent to the electronic device 128 and a message reply is received from the electronic device 128, or between when a request for a status of the electronic device 128 is sent to the electronic device 128 and a reply including the requested status is received from the electronic device 128.

The fuzzer 104 can receive feedback including an indication of a reboot of the electronic device 104. For example, the fuzzer 104 can monitor a state of the electronic device 128 (e.g., via state data received from the electronic device 128) to determine whether the electronic device 104 is performing a reboot. The fuzzer 104 can monitor the electronic device 104 for system side effects such as loss of independent function.

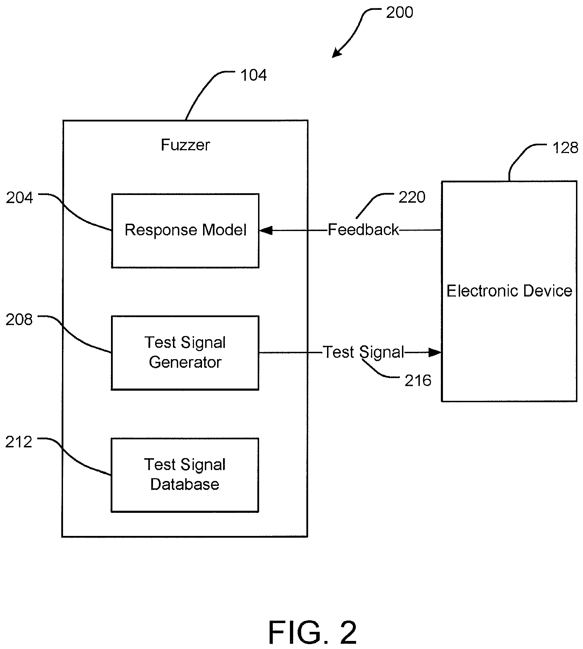

Referring now to FIG. 2, an embodiment of a fuzzing system 200 in accordance with the inventive concepts disclosed herein includes the fuzzer 104, which can include a response model 204 and a test signal generator 208. The response model 204 and test signal generator 208 can be implemented by the processing circuit 108 described with reference to FIG. 1. The test signal generator 208 can provide a test signal 216 to the electronic device 128 (e.g., via communications circuit 120 of FIG. 1). The response model 204 can receive feedback 220 regarding the electronic device 128 (e.g., based on feedback received by communications circuit 120 or sensors 124). The fuzzing system 200 can use the response model 204 and test signal generator 208 to perform actions such as synchronization of state between the fuzzer 104 and the electronic device 128, refining the response model 204 (e.g., updating or training the response model 204 using feedback 220), performing fine-grained exception detection, and evaluating code coverage.

The response model 204 can determine an expected response of the electronic device 128 to the test signal 216 based on the test signal 216. In some embodiments, the response model 204 applies one or more rules, policies, filters, functions, weights, or heuristics to the test signal 216 to generate the expected response. The response model 204 can determine the expected response to include at least one parameter of the electronic device 128 that the fuzzer 104 monitors using feedback 220. For example, the response model 204 can determine the expected response to include an amount of heat expected to be generated by the electronic device 128 responsive to the test signal 216.

In some embodiments, the response model 204 includes one or more machine learning models. The one or more machine learning models can be trained to generate expected (or predicted) responses of electronic devices 128 to test signals 216. The machine learning models can be trained using training data that includes a plurality of test signals 216 each associated with one or more respective parameters. The training data may also include various parameters regarding electronic devices 128, such as processing capacity, memory capacity, weight, average or baseline RF emissions, average or baseline temperature, or various other features that may be specific to each electronic device 128. The training data (e.g., test signals 216 and parameters) may be determined based on empirical measurement of parameters corresponding to specific electronic devices 128 responsive to receiving test signals 216.

The machine learning models can include unsupervised and supervised models. The unsupervised models can cluster the training data based on the one or more respective parameters of the training data, so that when the response model 204 receives the test signal 216 that is provided to the electronic device 128, the response model 204 can compare the test signal 216 to the clustered training data to determine the expected response of the electronic device 128 to the test signal 216.

The supervised models can include various models such as classification, regression, support vector machine (SVM), or Markov decision process engine models. The supervised models can be trained using labeled training data that includes known or true responses (e.g., values of parameters of feedback) of the electronic device 128 to test signals 216. For example, the response model 204 can be trained by providing input data that includes the test signals 216 to the response model 204, causing the response model 204 to generate a model output (e.g., parameter values) based on the input data, comparing the model output to the known responses, and modifying the response model 204 to reduce the difference between the model output and the known responses. An objective function (e.g., cost function) can be evaluated to compare the model output to the known responses and determine if and how to reduce the difference.

In some embodiments, the response model 204 includes one or more neural networks. The neural network can include a plurality of layers each including one or more nodes (e.g., neurons, perceptrons), such as a first layer (e.g., an input layer), a second layer (e.g., an output layer), and one or more hidden layers. The neural network can include characteristics such weights and biases associated with computations that can be performed between nodes of layers, which the fuzzer 104 (e.g., processing circuit 108 operating the response model 204) can modify to train the neural network.

In some embodiments, the neural network includes a convolutional neural network (CNN). The CNN can include one or more convolution layers, which can execute a convolution on values received from nodes of a preceding layer, such as to locally filter the values received from the nodes of the preceding layer. The CNN can include one or more pooling layers, which can be used to reduce a spatial size of the values received from the nodes of the preceding layer, such as by implementing a max pooling function, an average pooling function, or other pooling functions. The CNN can include one or more pooling layers between convolution layers. The CNN can include one or more fully connected layers, which may be similar to layers of neural networks by connecting every node in fully connected layer to every node in the preceding layer (as compared to nodes of the convolution layer(s), which are connected to less than all of the nodes of the preceding layer).

The fuzzer 104 can identify a detected response of the electronic device 128 to the test signal 216 using the feedback 220, and provide the detected response to the response model 204. For example, the response model 204 can identify at least one parameter of the electronic device 128 from the feedback 220 to determine the detected response. The at least one parameter can includes various parameters regarding the electronic device 128 described herein, including direct or indirect observables such as message replies, state information, RF emissions, power draw, temperature, heat generation, processor loading, message latencies, reboot events, and system side-effects, among others. The fuzzer 104 can perform various parsing processes to identify the observables from the feedback 220.

The fuzzer 104 can update the response model 204 using the detected response determined from the feedback 220. For example, the fuzzer 104 can provide a training data sample to the response model 204 that includes the test signal 216 and the detected response or one or more parameters of the detected response.

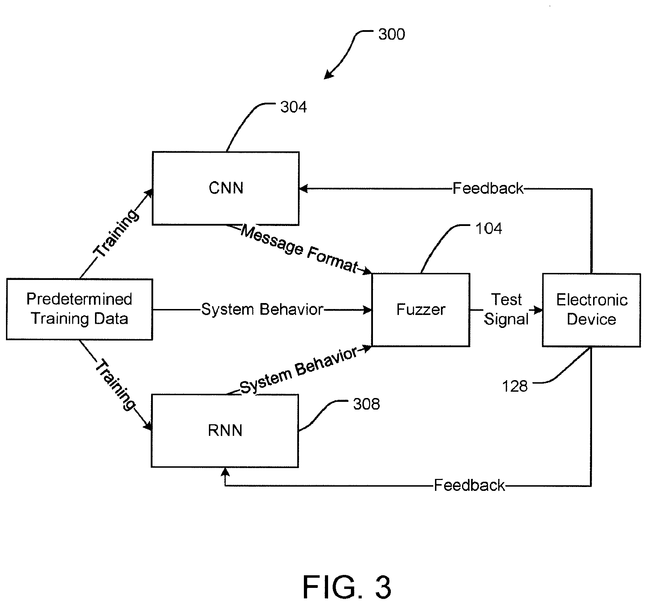

Referring further to FIG. 2 and now to FIG. 3, an embodiment of a machine learning system 300 according to the inventive concepts disclosed herein can be used by the fuzzer 104 to train and implement the response model 204, such as to train the response model 204 to extract message information form feedback 220 (or to train a model that operates with the response model 204 to provide message information to the response model 204). The machine learning system 300 can process feedback 220 such as message output, file reads and file writes, and processor and memory usage, to train and refine the response model 204 to perform automated message format discovery and enable concise constraint application to new message generation.

The machine learning system 300 can include a convolutional neural network (CNN) 304. The CNN 304 can be trained using training data that includes at least one of reverse engineered training data (e.g., protocol packet fields identified from applying predetermined rules to data streams) or feedback 220 received from the electronic device 128, to generate a message format. For example, the training data can include known or expected message format features mapped to respective messages, enabling the CNN 304 to identify relationships between the identifiable features of the messages (e.g., input to the CNN 304) and the message format (e.g., output). The CNN 304 can provide the message format to the fuzzer 104, such as to enable the test signal generator 208 of the fuzzer 104 to generate the test signal 216 in accordance with the message format. In some embodiments, the CNN 304 performs packet section identification responsive to the training data, enabling the CNN 304 to generate message format information.

The machine learning system 300 can include a recurrent neural network (RNN) 308. The RNN 308 can include similar features as the CNN 304, such as an input layer, one or more hidden layers, and an output layer. The nodes of the hidden layers can maintain and use state information. For example, the nodes of the hidden layers can generate outputs based on previously generated outputs.

The RNN 308 can receive training data including the at least one of reverse engineered training data (e.g., protocol packet fields identified from applying predetermined rules to data streams) or the feedback 220 received from the electronic device 128 to be trained to generate an output that includes system behavior of the electronic device 128. For example, the output of the RNN 308 can be analogous to the output of the response model 204. Accordingly, the machine learning system 300 can perform automated message discovery and formal verification of message behavior.

Referring further to FIG. 2, the test signal generator 208 can generate the test signal 216 to provide to the electronic device 128. The test signal generator 208 can generate the test signal 216 to include data to be used by the electronic device 128 to execute operations or instructions to be executed by the electronic device 128. The test signal generator 208 can generate the test signal 216 to include invalid, unexpected, or random data. The test signal 216 can include various characteristics, such as whether the test signal 216 includes random or pseudo-random data, a size of the signal, an entropy of the signal, a number of repeated elements of the signal, a frequency, phase, or magnitude of the signal, or various combinations of numbers, characters, strings, metadata, or binary data of the test signal 216.

In some embodiments, the test signal generator 208 generates the test signal 216 according to an expected protocol (e.g., format, application programming interface (API)) by which the electronic device 128 expects to receive input. For example, the test signal generator 208 can generate the test signal 216 to include headers, packet sizes, or other features according to which the electronic device 128 expects to receive input. This can enable the test signal generator 208 to generate test signals 216 that pass a pre-processor or parser that the electronic device 128 uses to filter inputs prior to further processing that is of interest to be tested using the test signal 216.

The test signal generator 208 can generate the test signal 216 based on at least one of the detected response determined via feedback 220 and the expected response determined by the response model 204, such as based on a difference between the detected response and the determined response. For example, the test signal generator 208 can compare one or more parameters of the detected response to one or more corresponding parameters of the expected response, and generate the test signal 216 based on the difference. For example, the one or more parameters can include an amount of heat generated by the electronic device 128 during a predetermined period of time subsequent to transmission of the test signal 216, and the test signal generator 208 can compare the amount of heat (e.g., as detected via one or more sensors 124) to an expected amount of heat to be generated based on applying the response model 204 to the test signal. Based on this comparison (e.g., to determine a difference between the amounts of heat), the test signal generator 208 can generate a new test signal 216 with different characteristics.

In some embodiments, the test signal generator 208 generates the test signal 216 to decrease a difference between the expected response and the detected response, such as if the expected response is a desired response. In some embodiments, the test signal generator 208 generates the test signal 216 to identify corner cases, such as by increasing an amount of randomly generated data of the test signal 216 responsive to the detected response indicating that the electronic device 128 processed the test signal 216 in a normal manner.

In some embodiments, the test signal generator 208 uses an evolutionary algorithm, such as a genetic algorithm, to generate the test signal 216. For example, the test signal generator 208 can apply the genetic algorithm to one or more characteristics of the test signal 216 (e.g., amount of randomness, data size or length), which can increase a rate at which the test signal generator 208 is able to generate test signals 216 that can vary the behavior space of the electronic device 128 that is investigated using the fuzzer 104.

In some embodiments, the fuzzer 104 includes a test signal database 212. The test signal database 212 can include various predetermined test signals or template test signals. The template test signals 216 can include at least some features of the test signals 216 to be generated by the test signal generator 208, such as a header or a data size, such as features that may be expected by the electronic device 128. The test signal generator 208 can retrieve the predetermined or template test signals from the test signal database 212 and generate the test signal 216 using the predetermined or template test signals. In some embodiments, each predetermined or template test signal of the test signal database 212 is associated with a key, which the test signal generator 208 can use to search the test signal database 212.

In some embodiments, the test signal generator 208 operates based on a state of the electronic device 128. As noted above, the state can correspond to an operational mode of the electronic device 128 (e.g., on, ready for processing, ready to receive inputs, processing inputs, sleep, hibernation) or a function being performed by the electronic device 128, among other states or statuses. The test signal generator 208 can use the state detected via feedback 220 to determine how to generate the test signal 216.

The test signal generator 208 can use the state detected via the feedback 220 to synchronize state between the fuzzer 104 and the electronic device 128. Synchronizing the state can enhance the performance and precision of the fuzzer 104, such as by reducing the time required to constrain the state of the electronic device 128 through state normalizing functions such as power cycles or resets. These state normalizing functions can take significant time to perform and can leave coverage gaps as other state transitions are not utilized as often. The more precisely the fuzzer 104 identifies the state of the electronic device 128, the more precisely the fuzzer 104 can detect behavior of the electronic device 128.

In some embodiments, the fuzzer 104 determines a state (e.g., estimated or expected state) of the electronic device 128 using the feedback 220 (e.g., direct or indirect observables). Responsive to the fuzzer 104 determining the state, the test signal generator 208 can at least one of (i) select a next test case to be used to generate the test signal 216 or (ii) perform a state normalizing function. The test signal generator 208 can select the next test case using information from the test signal database 212. The test signal generator 208 can select the next test case to correspond to a desired future state of the electronic device 128. The test signal generator 208, in some embodiments, can select the state normalizing function to be a function of lower cost (e.g., time or power usage), such as to cause the electronic device 128 to reconfigure rather than perform a power cycle. The test signal generator 208 can perform the state normalizing function using the test signal 216 to be provided to the electronic device 128, or by interfacing with a power controller of the electronic device 128 that may be separate from a communications interface that receives the test signal 216.

In some embodiments, the fuzzer 104 performs fine-grained exception detection. For example, the fuzzer 104 can detect, from the feedback 220, more specific observables than crash events, such as by detecting negative acknowledgements (NAKs). The fuzzer 104 can process the feedback 220 to detect observables such as error response messages, state inconsistencies between the fuzzer 104 and the electronic device 128 (e.g., an expected state of the electronic device 128 as determined by the response model 204 does not match a detected state of the electronic device 128 detected from the feedback 220), or side effects on other functions of the electronic device 128.

In some embodiments, the fuzzer 104 determines a coverage metric, such as a metric of code coverage, using the feedback 220. The coverage metric can represent a single or multidimensional (e.g., multi-parameter) space mapping the test signals 216 provided to the electronic device 128 to the response behaviors performed by the electronic device 128 that the fuzzer 104 measures using the feedback 220. For example, the fuzzer 104 can monitor a coverage metric corresponding to RF emissions, power draw, and heat generation in order to evaluate how great a range of (potential) values of these parameters the fuzzer 104 is able to induce in the operation of the electronic device 128 using the test signals 216.

The fuzzer 104 can map the feedback 220 to a value or range of values of the coverage metric and to the test signal 216 corresponding to the feedback 220. For example, the feedback 220 can include a message reply latency for the electronic device 128 to generate a message reply responsive to receiving the test signal 216. As the fuzzer 104 provides various test signals 216 to the electronic device 128, the fuzzer 104 can receive message replies having varying latency. The fuzzer 104 can map the latencies of the message replies to the coverage metric to determine how much of a latency space has been covered by the test signals 216. In some embodiments, the fuzzer 104 causes the test signal generator 208 to generate the test signal 216 to increase a total coverage corresponding to the coverage metric, enabling the fuzzer 104 to expand a space of behaviors of the electronic device 128 that can be detected and evaluated.

In some embodiments, the fuzzer 104 can compare the coverage metric to one or more threshold coverage metrics. The threshold coverage metric can represent a condition that when satisfied can trigger the fuzzer 104 to discontinue generating or modifying test signals 216. For example, the threshold coverage metric can indicate an amount of coverage to be satisfied. In some embodiments, the threshold coverage metric restricts attempts to generate test signals 216 corresponding to certain expected responses, enabling the fuzzer 104 to perform restriction guided fuzzing; for example, the threshold coverage metric may indicate a temperature or amount of heat generation not to be exceeded when testing the electronic device 128.

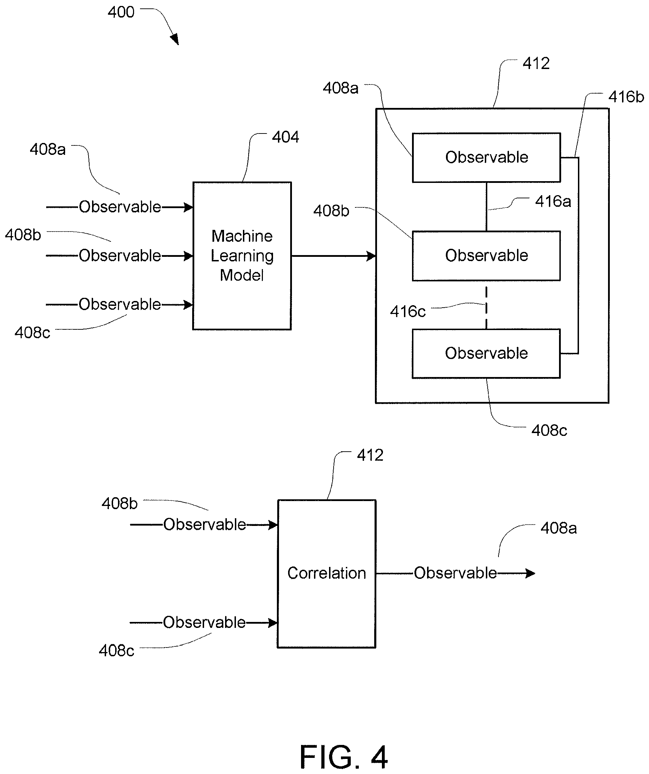

Referring now to FIG. 4, an example of a process 400 for correlating feedback using a machine learning model 404 according to the inventive concepts disclosed herein can enable the fuzzer 104 to more effectively detect behaviors of the electronic device 128. As described herein, the feedback 220 may include a large variety of observables relating to the behavior of the electronic device 128, such as processing load, power consumption, temperature, and memory usage. Certain observables may be more difficult to detect. For example, observables may be difficult to detect in terms of being able to read feedback from messages outputted by the electronic device 128 that indicates the observables, to cause the electronic device 128 to enter a state in which the observable can be detected with sufficient confidence, a duration of time needed to detect the observable, or a duration of time needed to reset or reconfigure the electronic device 128 once the observable has been detected with sufficient confidence, among various other such considerations.

The fuzzer 104 can use the machine learning model 404 together with or separately from the response model 204 described with reference to FIGS. 2 and 3 to process feedback 220 from the electronic device 128 and generate correlations between different types of observables. This can enable the fuzzer 104 to indirectly detect relatively costly observables based on detecting less costly observables that are correlated with the relatively costly observables. For example, memory overflow detection may be difficult or expensive to measure, so that the fuzzer 104 can use other observables correlated to memory overflow detection, such as temperature or message reply latency, to identify memory overflow detection. The fuzzer 104 can use the machine learning model 404 in situations such as transitioning between a virtual platform and a physical platform by gathering training data from the virtual platform in order to identify correlated observables from the physical platform (for which it may be difficult to detect the correlated observables). The fuzzer 104 can use the machine learning model 404 to estimate an otherwise hidden inner state of the electronic device 128 based on other observables that are correlated with the hidden inner state.

As shown in FIG. 4, the machine learning model 404 can receive several observables 408a, 408b, 408c (generally referred to as observables 408). The observable 408a may be a relatively costly observable as compared to the observables 408b, 408c. The machine learning model 404 can receive the observables 408 as training data, such as if the observables 408 were generated responsive to the same test signal 216. The machine learning model 404 may also be provided the test signal 216 with the observables 408.

The machine learning model 404 can operate on the training data to generate a correlation data structure 412 (e.g., a correlation model generated upon training the machine learning model 404). The correlation data structure 412 can include one or more functions, filters, or other relationships amongst the observables 408. The machine learning model 404 can include one or more models, such as regressions or neural networks, that can be applied to the training data to generate the correlation data structure 412. As illustrated in FIG. 4, the machine learning model 404 can determine a correlation 416a between the observable 408b and the observable 408a, a correlation 416b between the observable 408c and the observable 408a, and a correlation 416c between the observable 408c and the observable 408b. The correlations 416a, 416b, 416c may include various weights, biases, functions, or filters that can be applied, for example, to the observable 408c to estimate a value of the observable 408a.

The fuzzer 104 can provide the observables 408b, 408c (e.g., responsive to parsing the feedback 220) to the correlation 412 to generate the observable 408a (e.g., without using the sensors 124 to detect feedback 220 that includes the observable 408a or perform the processing to identify the observable 408a from the feedback 220). As such, the fuzzer 104 can reduce the cost needed to identify the observable 408a.

Referring further to FIG. 2, in some instances, it can be difficult to effectively detect anomalies because of a relatively limited number of true positives (e.g., true cyber anomalies). For example, the parameter space of tests cases used to generate test signals 216 may have significantly greater more uninteresting test cases that cause normal behavior from the electronic device 128 than interesting or edge cases that can induce a software bug or other behavior targeted by the fuzzing. In addition, certain bugs may be subtle (e.g., false negatives that cannot be easily distinguished from true negative), or the electronic device 128 may generate inconsistent or unreliable observables (e.g., false positives).

The fuzzer 104 can cause the test signal generator 208 to generate test signals 216 using known vulnerabilities, such as test signal data maintained in test signal database 212 corresponding to known vulnerabilities (e.g., test signal data known to cause the electronic device 128 to undergo a bug). For example, the test signal generator 208 can generate a test signal 216 that corresponds to a known vulnerability. The fuzzer 104 can associate the feedback 220 corresponding to operation of the electronic device 128 responsive to the electronic device 128 receiving test signal 216, including an indication that the feedback 220 indicates a true positive (e.g., abnormal behavior of the electronic device 128). As such, the fuzzer 104 can generate more effective training data samples for training the response model 204, enabling the response model 204 to more effectively generate expected responses. For example, the fuzzer 104 can more effectively determine margins between positive and negative observables.

Similarly, the fuzzer 104 can monitor feedback 220 during known normal operation of the electronic device 128, to generate known negative observables. Accordingly, the fuzzer 104 can generate an anomaly detection algorithm, such as the response model 204, that can more effectively distinguish positive observables (e.g., software bugs) from negative observables (e.g., normal operation).

As an example, the electronic device 128 may be configured to improperly handle an exceptional source address in a network reply request. The test signal generator 208 can generate a test signal 216 using data from the test signal database 212 that includes an exceptional source address, and provide the test signal 216 to the electronic device 128. The electronic device 128 will read the exceptional source address and attempt to transmit a packet using the provided data; as a result, the transmitting portion of the software stack of the electronic device 128 reads into valid (but not appropriate for the execution path) memory and ceases to continue normal operation, resulting in no further transmission. CPU and RAM usage of the electronic device 128 may remain stable. In this example, an observable temperature of the electronic device 128 may decrease due to termination of normal transmission. The fuzzer 104 can detect the temperature data from feedback 220, and generate a positive test case to be used for training that associates the temperature data with the test signal 216 and an indication that the test signal 216 is a positive test signal 216.

In some embodiments, the fuzzer 104 can identify information from data packets according to the inventive concepts disclosed herein. The fuzzer 104 can identify and classify network traffic using packet traffic analysis, including for non-standard, binary protocols, and to extract custom packet fields and protocol behavior in a more efficient manner. The fuzzer 104 can use the information extracted from the data packets (e.g., network traffic outputted by the electronic device 128) to generate training data samples to be used to train the response model 204. As such, the fuzzer 104 can more effectively detect observables from targets such as embedded targets and targets that use non-standard or arbitrary protocols. For example, the fuzzer 104 can identify a characteristic of a particular byte of a data packet, or that seventh and eighth bits of a data packet indicate a particular mode change.

The fuzzer 104 can receive a data stream (e.g., byte stream) from the electronic device 128. The fuzzer 104 can apply an isolation process to the data stream to identify one or more flows of the data stream. Each flow can correspond to one or more data packets (e.g., sets of traffic) transmitted from a first node for reception by a second node in a network in which the electronic device 128 communicates. By identifying the one or more flows, the fuzzer 104 can individually process each flow.

In some embodiments, the fuzzer 104 identifies the one or more flows by applying a clustering algorithm to the data stream. For example, the fuzzer 104 can apply a K-means or mean-shift algorithm to the data stream. The fuzzer 104 can extract various features of the data stream to provide to the clustering algorithm, based on which the fuzzer 104 can cluster the data stream into the one or more flows.

In some embodiments, the fuzzer 104 evaluates the clustering based on an evaluation condition. The evaluation condition can include a performance condition, such as processing demand required to perform the clustering. In some embodiments, responsive to the clustering not satisfying the evaluation condition (e.g., the clustering taking a greater amount of time than a threshold amount of time), the fuzzer 104 can switch to a different process to identify the one or more flows, such as by sorting portions of the data stream by length.

The fuzzer 104 can perform one or more statistical analyses responsive to identifying the one or more flows. For example, the fuzzer 104 can identify means, medians, standard deviations, covariances, or other statistical features of each flow. By applying the statistical analyses, the fuzzer 104 can identify values such as random fields, constants, checksums, lengths, and ranges for each field of the flow. The fuzzer 104 can maintain a confidence level associated with each value (e.g., 95 percent confidence level), and at least one of iteratively update the statistical analyses or determine a field to be unknown responsive to the confidence level not satisfying an appropriate threshold.

The fuzzer 104 can apply one or more machine learning models to each flow (prior to or subsequent to the statistical analyses) to identify values of incrementing or periodic fields, such as counters, sequence numbers, or bit flag fields. For example, the fuzzer 104 can apply a convolutional neural network trained using training data samples that associate statistical values of flows to the corresponding values of the fields of the flows. In some embodiments, the fuzzer 104 applies a recurrent neural network to the identified fields to generate a model for packet generation. In some embodiments, applies a hidden Markov model to the identified fields to model features such as state interaction between fields over time.

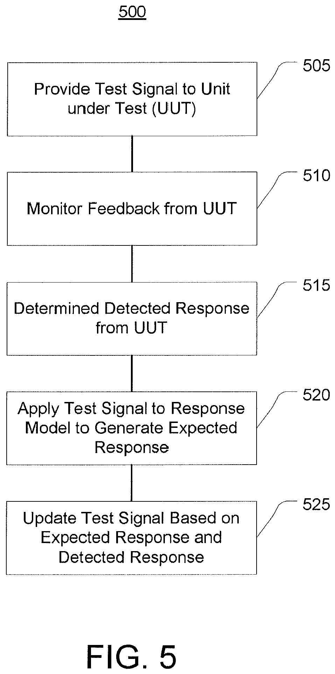

Referring now to FIG. 5, an embodiment of a method 500 according to the inventive concepts disclosed herein can include one or more of the following steps. The method 500 can be performed by various systems and devices described herein, including the fuzzer 104.

A step (505) can include providing a test signal to a UUT. The test signal can be provided by a fuzzer. The test signal can be configured to cause the UUT to perform abnormal behavior, such as to a cause a memory exception. The test signal can include data to be used by the UUT to execute operations or instructions to be executed by the UUT. The test signal can include invalid, unexpected, or random data. The test signal can include various characteristics, such as whether the test signal includes random or pseudo-random data, a size of the signal, an entropy of the signal, a number of repeated elements of the signal, a frequency, phase, or magnitude of the signal, or various combinations of numbers, characters, strings, metadata, or binary data of the test signal. In some embodiments, the test signal is generated according to an expected protocol (e.g., format, application programming interface (API)) by which the UUT expects to receive input. For example, the test signal can include headers, packet sizes, or other features according to which the UUT expects to receive input. In some embodiments, the test signal includes a header configured according to a format excepted by the UUT and a payload comprising at least some random or pseudo-random data.

The test signal can be provided responsive to a request to test the UUT. The test signal can be provided on a periodic basis, such as according to a test schedule. The test signal can be provided via a wired or wireless connection with the UUT (e.g., with a wired or wireless receiver of the UUT).

A step (510) can include monitoring feedback from the UUT. The UUT can be monitored for feedback for a predetermined duration of time subsequent to the test signal being provided to the UUT. The UUT can be monitored for feedback that can include direct observables (e.g., observables that can be identified or extracted from a message reply outputted by the UUT) or indirect observables (e.g., observables detected using one or more sensors that detect behaviors of the UUT during or after receiving the test signal, but which are not generated by an electronic instruction that the UUT performs during or after processing the test signal).

In some embodiments, the feedback is monitored using a communications circuit that can receive a message reply from the UUT via a wired or wireless connection with the UUT, such as via a connection established by at least one of the device providing the test signal or the UUT requesting the connection, and at least one of the other of the device providing the test signal or the UUT acknowledging the connection. In some embodiments, the feedback is monitored using the one or more sensors, which may include any of a variety of sensors, such as an RF emissions detector, a power sensor, or a temperature sensor.

A step (515) can include determining a detected response from the feedback. The detected response can be determined from feedback detected by at least one of the communications circuit or the one or more sensors. For example, the detected response can include parameters such as temperature of the UUT or heat generated by the UUT, RF emissions outputted by the UUT, or power usage by the UUT.

In some embodiments, the detected response indicates a state of the UUT, such as a state that the UUT outputs periodically, responsive to a state change, or responsive to receiving a request from the fuzzer. For example, the fuzzer can transmit a query to the UUT for the status, which the UUT can provide responsive to the query. The fuzzer can operate a JTAG debugger to query the UUT for the state. The state can correspond to an operational mode of the UUT (e.g., on, ready for processing, ready to receive inputs, processing inputs, sleep, hibernation) or a function being performed by the UUT. The state can indicate an amount of processing load, or processing capacity or memory capacity available for operation by the UUT. The state can indicate a network connection status or characteristic, such as latency. The state can include a current step of a protocol or an operational configuration of the UUT.

The detected response can include an indication of processor loading. For example, the feedback can be parsed to detect a duration of time that one or more processors of the UUT are in a loading state.

In some embodiments, the detected response includes an indication of message latency. For example, a duration of time can be monitored between when a test signal is sent to the UUT and a message reply is received from the UUT, or between when a request for a status of the UUT is sent to the UUT and a reply including the requested status is received from the UUT.

In some embodiments, the detected response includes an indication of a reboot of the UUT. For example, the fuzzer can monitor a state of the UUT (e.g., via state data received from the UUT) to determine whether the UUT is performing a reboot. The fuzzer can monitor the UUT for system side effects such as loss of independent function.

A step (520) can include applying the test signal to a response model to determine an expected response of the UUT to the test signal. In some embodiments, the response model applies one or more rules, policies, filters, functions, weights, or heuristics to the test signal to generate the expected response. The response model can determine the expected response to include at least one parameter of the UUT that the fuzzer monitors using the feedback received from the UUT. For example, the response model can determine the expected response to include an amount of heat expected to be generated by the UUT responsive to the test signal. The test signal can be applied to the response model responsive to each instance or cycle of feedback detection or responsive to each instance in which a test signal is applied to the UUT.

In some embodiments, the response model includes one or more machine learning models. The one or more machine learning models can be trained to generate expected (or predicted) responses of UUTs to test signals. The machine learning models can be trained using training data that includes a plurality of test signals each associated with one or more respective parameters. The training data may also include various parameters regarding UUTs, such as processing capacity, memory capacity, weight, average or baseline RF emissions, average or baseline temperature, or various other features that may be specific to each UUT. The training data (e.g., test signals and parameters) may be determined based on empirical measurement of parameters corresponding to specific UUTs responsive to receiving test signals.

In some embodiments, the response model is updated by providing training data to the response model that includes the test signal and the corresponding feedback received. In some embodiments, the response model is trained by providing input data that includes one or more test signals and corresponding known responses (e.g., known feedback) to the response model, causing the response model to generate a model output (e.g., parameter values) based on the input data, comparing the model output to the known responses, and modifying the response model to reduce the difference between the model output and the known responses.

An objective function (e.g., cost function) can be evaluated to compare the model output to the known responses and determine if and how to reduce the difference.

The detected response can be determined for at least some parameters without observing the parameters, such as for relatively costly parameters. For example, the feedback can be applied to a correlation model that correlates one or more first parameters (e.g., temperature, power usage) to one or more second parameters (e.g., memory usage) to determine the one or more second parameters.

A step (525) can include updating the test signal based on at the detected response and the expected response. For example, the test signal can be updated (e.g., a new test signal generated) based on a difference between the detected response and the determined response. For example, one or more parameters of the detected response can be compared to one or more corresponding parameters of the expected response, and the test signal can be generated based on the difference. For example, the one or more parameters can include an amount of heat generated by the UUT during a predetermined period of time subsequent to transmission of the test signal, and the amount of heat (e.g., as detected via one or more sensors) can be compared to an expected amount of heat to be generated based on applying the response model to the test signal. Based on this comparison (e.g., to determine a difference between the amounts of heat), a new test signal can be generated with different characteristics.

In some embodiments, the test signal is generated to decrease a difference between the expected response and the detected response, such as if the expected response is a desired response. In some embodiments, the test signal is generated to identify corner cases, such as by increasing an amount of randomly generated data of the test signal responsive to the detected response indicating that the UUT processed the test signal in a normal manner.

In some embodiments, an evolutionary algorithm, such as a genetic algorithm, is used to generate the test signal. For example, the genetic algorithm can be applied to one or more characteristics of the test signal (e.g., amount of randomness, data size or length).

A state detected via the feedback can be used to synchronize state between the fuzzer and the UUT. Synchronizing the state can reduce the time required to constrain the state of the UUT through state normalizing functions such as power cycles or resets. These state normalizing functions can take significant time to perform and can leave coverage gaps as other state transitions are not utilized as often. The more precisely the state of the UUT is identified, the more precisely the behavior of the UUT can be detected.

In some embodiments, a state (e.g., estimated or expected state) of the UUT is detected using the feedback (e.g., direct or indirect observables). Responsive to determining the state, at least one of (i) selecting a next test case to be used to generate the test signal or (ii) performing a state normalizing function can be performed. The next test case can be selected to correspond to a desired future state of the UUT. In some embodiments, the state normalizing function can be selected to be a function of lower cost (e.g., time or power usage), such as to cause the UUT to reconfigure rather than perform a power cycle. The state normalizing function can be performed using the test signal to be provided to the UUT, or by interfacing with a power controller of the UUT that may be separate from a communications interface that receives the test signal.

In some embodiments, the feedback can be processed to detect observables such as error response messages, state inconsistencies between the fuzzer and the UUT (e.g., an expected state of the UUT as determined by the response model does not match a detected state of the UUT detected from the feedback), or side effects on other functions of the UUT.

In some embodiments, a coverage metric, such as a metric of code coverage, can be determined using the feedback. The coverage metric can represent a single or multidimensional (e.g., multi-parameter) space mapping the test signals provided to the UUT to the response behaviors performed by the UUT measured using the feedback. For example, a coverage metric corresponding to RF emissions, power draw, and heat generation can be monitored in order to evaluate how great a range of (potential) values of these parameters that can be induced in the operation of the UUT using the test signals.

As will be appreciated from the above, systems and methods for fuzzing with feedback can be used to improve software and firmware testing by enabling more detailed and accurate detection of the responses of the software or firmware to test cases. As such, test cases can be more efficiently selected and used to identify corner cases or other unusual behavior that is desired to be induced in the UUT. Such solutions can thus reduce the processing demand needed to effectively test the UUT.

It is to be understood that embodiments of the methods according to the inventive concepts disclosed herein may include one or more of the steps described herein. Further, such steps may be carried out in any desired order and two or more of the steps may be carried out simultaneously with one another. Two or more of the steps disclosed herein may be combined in a single step, and in some embodiments, one or more of the steps may be carried out as two or more sub-steps. Further, other steps or sub-steps may be carried in addition to, or as substitutes to one or more of the steps disclosed herein.

From the above description, it is clear that the inventive concepts disclosed herein are well adapted to carry out the objects and to attain the advantages mentioned herein as well as those inherent in the inventive concepts disclosed herein. While presently preferred embodiments of the inventive concepts disclosed herein have been described for purposes of this disclosure, it will be understood that numerous changes may be made which will readily suggest themselves to those skilled in the art and which are accomplished within the broad scope and coverage of the inventive concepts disclosed and claimed herein.

## Claims

1. A method, comprising:
providing (505), by one or more processors (112) to an electronic device (128), a first test signal (216);
monitoring, (510) by the one or more processors, at least one parameter of the electronic device during a time period subsequent to the test signal being provided to the electronic device;
determining (515), by the one or more processors based on the at least one parameter, a detected response of the electronic device to the first test signal;
determining (520), by the one or more processors using a response model (204), an expected response of the electronic device to the first test signal; and
providing (525), by the one or more processors to the electronic device, a second test signal (216) based on the detected response and the expected response.

2. The method of claim 1, wherein monitoring the at least one parameter includes receiving, by the one or more processors, the at least one parameter from one or more sensors (124) that detect the at least one parameter,
optionally wherein the at least one parameter includes at least one of a power usage, radio frequency (RF) emission, or heat generation parameter.

3. The method of claim 1 or 2, comprising:
determining, by the one or more processors, a state of the electronic device based on the detected response; and
generating, by the one or more processors, the second test signal based on the state of the electronic device.

4. The method of any preceding claim, comprising updating the response model based on the detected response and the expected response.

5. The method of any preceding claim, comprising determining, by the one or more processors, a coverage score associated with the first test signal based on the detected response.

6. The method of any preceding claim, wherein the response model includes a neural network,
and/or wherein the response model is trained using training data corresponding to a known vulnerability and one or more observed parameters corresponding to the known vulnerability.

7. The method of any preceding claim, wherein determining the detected response includes identifying at least one second parameter correlated with the at least one parameter,
optionally wherein the at least one second parameter is determined to be correlated with the at least one parameter by providing test signals to a virtual platform.

8. The method of any preceding claim, further comprising applying one or more machine learning models (404) to feedback (220) received by the response model (204) to identify at least one format or packet structure of the feedback.

9. A system, comprising:
one or more processors (112); and
computer-readable instructions that when executed by the one or more processors, cause the one or more processors to:
provide a first test signal (216) to an electronic device (128);
monitor at least one parameter of the electronic device during a time period subsequent to the test signal being provided to the electronic device;
determine, based on the at least one parameter, a detected response of the electronic device to the first test signal;
determine, using a response model (204), an expected response of the electronic device to the first test signal; and
provide a second test signal (216) based on the detected response and the expected response to the electronic device.

10. The system of claim 9, further comprising one or more sensors (124) that detect the at least one parameter,
optionally wherein the at least one parameter includes at least one of a power usage, radio frequency (RF) emission, or heat generation parameter.

11. The system of claim 9 or 10, wherein the one or more processors determine a state of the electronic device based on the detected response and generate the second test signal based on the state of the electronic device,
optionally wherein the one or more processors generate the second test signal to synchronize the state of the electronic device with an expected state of the electronic device maintained in memory (116) by the one or more processors.

12. The system of any of claims 9 to 11, wherein the one or more processors update the response model based on the detected response and the expected response.

13. The system of any of claims 9 to 12, wherein the one or more processors generate the first test signal based on a known vulnerability of the electronic device.

14. The system of any of claims 9 to 13, wherein the one or more processors determine a coverage score associated with the first test signal based on the detected response.

15. The system of any of claims 9 to 14, wherein the one or more processors determine the detected response by identifying at least one second parameter correlated with the at least one parameter.
